# EUROPÄISCHE PATENTANMELDUNG

(11) **EP 4 080 554 A2**
(43) Veröffentlichungstag der Anmeldung: **26.10.2022**
(21) Anmeldenummer: 22169041.5
(22) Anmeldetag: 20.04.2022
(51) Int. Cl.: H01L 21/67, H01L 21/60

(54) **SINTERVORRICHTUNG UND VERFAHREN ZUM STEUERN EINER SINTERVORRICHTUNG**

(30) Priorität: 21.04.2021 DE 102021110080
(71) Anmelder: PINK GmbH Thermosysteme, 97877 Wertheim (DE)
(72) Erfinder: Oetzel, Christoph, 97877 Wertheim (DE); Ulrich, Holger, 97877 Wertheim (DE)
(74) Vertreter: Spachmann, Holger

(57) **Zusammenfassung**

Eine erfindungsgemäße Sintervorrichtung zum gleichzeitigen Verbinden von Komponenten mehrerer nebeneinander angeordneter elektronischer Baugruppen mittels Drucksintern umfasst mindestens einen ersten Pressstempel und mindestens einen zweiten Pressstempel, zwischen denen die Baugruppen aufgenommen sind und welche zum Ausüben einer Presskraft relativ zueinander bezüglich ihres Abstands versetzbar sind, wobei die ersten und/oder die zweiten Presstempel zur Anpassung an eine jeweilige Höhe und/oder Position der Baugruppen konfigurierbar sind. Die Erfindung betrifft ferner ein Verfahren zum Steuern einer derartigen Sintervorrichtung.

## Beschreibung

Die vorliegende Erfindung betrifft eine Sintervorrichtung zum Verbinden von Komponenten elektronischer Baugruppen mittels Drucksintern.

Des Weiteren betrifft die Erfindung ein Verfahren zum Steuern einer derartigen Sintervorrichtung.

### STAND DER TECHNIK

Beim Drucksintern können zwei oder mehr Komponenten, insbesondere elektronische Bauteile und Substrate, mittels eines Fügewerkstoffs miteinander elektrisch und/oder thermisch leitend verbunden werden, wobei hierbei der verbindende Fügewerkstoff gesintert wird. Die zu verbindenden Komponenten werden für die Bereitstellung eines Fügedrucks hierbei uniaxial zwischen einem Oberwerkzeug und einem Unterwerkzeug verpresst.

Es hat sich herausgestellt, dass eine Verbindungsherstellung unter Prozessatmosphäre, insbesondere Unterdruck oder Vakuum, besonders vorteilhaft ist, insbesondere zur Unterbindung unerwünschter chemischer Reaktionen wie Oxidation, zur Verhinderung von Gaseinschlüssen und zur Unterbindung von Verunreinigungen. Zum Sintern notwendige Wärme wird in der Regel über das Oberwerkzeug und das Unterwerkzeug auf die Komponenten übertragen, kann aber auch von der Unter- und/oder Oberseite als Strahlungswärme aufgebracht werden. Oftmals sollen auf einem gemeinsamen Substrat mehrere Bauteile angeordnet werden, die sich sowohl hinsichtlich ihrer lateralen Ausdehnung als auch ihrer Höhe voneinander unterscheiden können. Um eine gleichmäßige Druckübertragung zu gewährleisten, können am Oberwerkzeug und/oder am Unterwerkzeug mehrere Pressstempel vorgesehen werden, die in ihren Dimensionen auf die zu verbindenden Komponenten abgestimmt sind.

Sollen auf einer Anlage verschiedene Baugruppen unterschiedlicher Art verarbeitet werden, ist regelmäßig eine Anpassung der Pressstempelanordnung am Ober- bzw. Unterwerkzeug erforderlich. Die Anpassung ist zeitaufwendig und wird dadurch erschwert, dass die Werkzeuge und/oder Pressstempel heiß sein können. Zudem sind die Werkzeuge, insbesondere die Pressstempel, üblicherweise aus Metall, da sie hohen Druckkräften standhalten müssen. Daher sind solche Werkzeuge schwer, kühlen langsam ab und sind kostenintensiv. Des Weiteren ist eine exakte Lageausrichtung der Werkzeuge bzw. der Pressstempel zu den zu verbindenden Komponenten erforderlich.

Oftmals weisen die zu verbindenden Komponenten unterschiedliche Wärmeausdehnungskoeffizienten auf. Nach dem Sintern und dem nachfolgenden Abkühlen können innerhalb der Baugruppe mechanische Spannungen auftreten, die zu Beschädigungen und/oder Fehlfunktionen der miteinander verbundenen Komponenten führen.

Es ist eine Aufgabe der Erfindung, eine Sintervorrichtung zu schaffen, die eine schnelle und zuverlässige Anpassung an die zu verbindenden Komponenten erlaubt, wobei bevorzugt mechanische Spannungen in einer aus den Komponenten hergestellten Baugruppe reduziert werden sollen.

### OFFENBARUNG DER ERFINDUNG

Die Lösung der Aufgabe erfolgt durch eine Sintervorrichtung mit den Merkmalen des Anspruchs 1. Bevorzugte Ausführungsformen sind in den Unteransprüchen angegeben.

Eine erfindungsgemäße Sintervorrichtung zum gleichzeitigen Verbinden von Komponenten mehrerer nebeneinander angeordneter elektronischer Baugruppen mittels Drucksintern umfasst mindestens einen ersten Pressstempel und mindestens einen zweiten Pressstempel, zwischen denen die Baugruppen aufgenommen sind und welche zum Ausüben einer Presskraft relativ zueinander bezüglich ihres Abstands versetzbar sind, wobei die ersten und/oder die zweiten Presstempel zur Anpassung an eine jeweilige Höhe und/oder Position der Baugruppen konfigurierbar sind. Bevorzugt ist der mindestens eine Pressstempel an einem Oberwerkzeug angeordnet bzw. Bestandteil eines Oberwerkzeugs und der mindestens eine zweite Pressstempel an einem Unterwerkzeug angeordnet bzw. Bestandteil eines Unterwerkzeugs. Demnach wirkt der mindestens eine erste Pressstempel von oben auf die Baugruppen, während der mindestens eine zweite Pressstempel von unten auf die Baugruppen wirkt. Grundsätzlich ist jedoch auch eine umgekehrte Anordnung der Presstempel möglich, d.h. der mindestens eine erste Pressstempel ist dem Unterwerkzeug und der mindestens eine zweite Pressstempel dem Oberwerkzeug der Sintervorrichtung zugeordnet. Die Konfiguration der Pressstempel zur Anpassung an eine jeweilige Höhe und/oder Position der Baugruppe erfolgt bevorzugt werkzeugfrei. Die zu verbindenden Komponenten können einzelne Bauelemente oder auch Bauteile oder Bauteilstapel umfassen, die aus mehreren vorab zusammengefügten Bauelementen zusammengesetzt sind.

Gemäß einer bevorzugten Ausführungsform umfasst die Sintervorrichtung mehrere erste Pressstempel, welche an einer gemeinsamen Halterungsplatte angeordnet sind. Die Anordnung der ersten Pressstempel an einer gemeinsamen Halterungsplatte ermöglicht eine Vorkonfiguration der ersten Pressstempel, wobei zum Beispiel Pressstempel mit unterschiedlicher Höhe und/oder unterschiedlich großer Pressfläche an der Halterungsplatte angeordnet werden können. Die ersten Pressstempel sind bevorzugt austauschbar an der gemeinsamen Halterungsplatte angeordnet, so dass eine Konfigurationsänderung der Pressstempelanordnung zur Anpassung an unterschiedliche Baugruppen unter Wiederverwendung der Halterungsplatte bzw. der Pressstempel erfolgen kann.

Gemäß einer weiteren bevorzugten Ausführungsform ist die Halterungsplatte an einer bevorzugt temperierbaren Grundplatte der Sintervorrichtung lösbar mittels einer Spannvorrichtung befestigt. Ein Auswechseln der ersten Pressstempel kann demnach durch einen Austausch der mit Presstempeln bestückten Halterungsplatte erfolgen, so dass bei einer Konfigurationsänderung keine einzelnen Pressstempel gehandhabt werden müssen, sondern die komplette Halterungsplatte ausgetauscht werden kann. Dadurch kann eine Anpassung der Pressstempelkonfiguration, die beispielsweise durch eine Umkonfigurierung der Sintervorrichtung zur Anpassung an eine geänderte Bestückung oder Topologie der Baugruppen bedingt sein kann, innerhalb von kurzer Zeit vorgenommen werden. Falls die Grundplatte temperierbar ist, d.h. zumindest heizbar, bevorzugt auch kühlbar ist, kann eine Temperierung der ersten Pressstempel durch einen Wärmeaustausch zwischen der temperierbaren Grundplatte und den ersten Pressstempeln erfolgen, wobei hier sowohl ein direkter Wärmeaustausch als auch ein indirekter Wärmeaustausch über die Halterungsplatte vorgesehen sein kann. Die Spannvorrichtung ist bevorzugt werkzeugfrei betätigbar. Gemäß einer weiteren bevorzugten Ausführungsform weist die Spannvorrichtung mehrere manuell oder motorisch rotierbare Wellen auf, welche jeweils an einem freien Ende einen, bevorzugt als Exzenterscheibe ausgebildeten, Verriegelungsabschnitt aufweisen, wobei die Wellen zwischen einer Verriegelungsstellung, in welcher die Halterungsplatte mittels der Verriegelungsabschnitte an der Grundplatte festgelegt ist, und einer Freigabestellung, in welcher die Verriegelungsabschnitte die Halterungsplatte freigeben, rotierbar ist. Die Halterungsplatte wird somit mit Hilfe der Verriegelungsabschnitte an der Grundplatte verklemmt. Hierdurch ist ein rasches Lösen und Wiederherstellen der Verbindung zwischen der Halterungsplatte und der Grundplatte möglich. Grundsätzlich ist ein motorisches Rotieren der Wellen bevorzugt, da dies den Austausch der Halterungsplatte nochmals beschleunigt und die Gefahr von Verbrennungen für einen Benutzer im Vergleich zu einem manuellen Rotieren der Wellen reduziert. Ein motorisches Rotieren der Wellen kann beispielsweise mit Hilfe von Getriebemotoren oder pneumatisch erfolgen. Für ein manuelles Rotieren können beispielsweise Handräder vorgesehen sein.

Gemäß einer weiteren bevorzugten Ausführungsform sind die ersten Pressstempel bei einer ersten Temperatur entlang einer Wirkrichtung der Presskraft versetzbar an oder in der Halterungsplatte aufgenommen und bei einer zweiten Temperatur, die höher ist als die erste Temperatur, an oder in der Halterungsplatte verklemmt. Hierdurch kann insbesondere eine rasche und präzise Anpassung an jeweilige Baugruppen erfolgen, bei denen die verschiedenen Komponenten eine unterschiedliche Höhe aufweisen. So können beispielsweise die ersten Pressstempel bei der ersten, d.h. niedrigen Temperatur soweit an die zu verbindenden Baugruppen oder eine entsprechende Richtlehre angenähert werden, bis alle Kontaktflächen der ersten Pressstempel mit jeweils zugeordneten Bauteilen in Kontakt stehen. Dabei werden diejenigen Pressstempel, die mit relativ hohen Komponenten oder Bauteilen in Kontakt stehen, weiter versetzt als diejenigen Pressstempel, die mit Komponenten oder Bauteilen mit vergleichsweise niedriger Höhe in Kontakt stehen. Wenn sich die Pressstempel bezüglich ihrer Längsposition an die Bauteile bzw. die Baugruppen angepasst haben, erfolgt eine Temperaturerhöhung der ersten Pressstempel und der Halterungsplatte. Dadurch werden die ersten Pressstempel an oder in der Halterungsplatte verklemmt und somit bezüglich ihrer Längs- oder Axialposition fixiert. Durch das Verklemmen wird ein Kraftschluss zwischen den ersten Pressstempeln und der Halterungsplatte hergestellt.

Gemäß einer bevorzugten Ausführungsform weist die Halterungsplatte zumindest in einem mit jeweiligen, mit einem der ersten Pressstempel zusammenwirkenden Teilabschnitt einen höheren oder einen niedrigeren Wärmeausdehnungskoeffizienten auf als der jeweilige erste Pressstempel. Durch die Unterschiede des Wärmeausdehnungskoeffizienten der Halterungsplatte bzw. des Teilabschnitts einerseits und des Wärmeausdehnungskoeffizienten des jeweiligen ersten Pressstempel andererseits wird durch die Temperaturerhöhung der zum Verklemmen erforderliche Kraftschluss hergestellt und durch Abkühlen wieder aufgehoben.

Gemäß einer weiteren bevorzugten Ausführungsform umfasst die Sintervorrichtung mehrere unabhängig voneinander versetzbare zweite Pressstempel, wobei jedem der zweiten Pressstempel eine jeweilige Antriebsvorrichtung zum axialen Versetzen dieses Pressstempels entlang einer Wirkrichtung der Presskraft zugeordnet ist, und wobei jede Antriebsvorrichtung hinsichtlich eines Versatzwegs und/oder einer ausgeübten Presskraft individuell, bevorzugt hydraulisch, elektromotorisch, piezoelektrisch oder magnetostriktiv, ansteuerbar ist. Bevorzugt ist ein jeweiliger zweiter Pressstempel einer jeweiligen Baugruppe zugeordnet. Dadurch ist es möglich, die verschiedenen Baugruppen mit einem gleichmäßigen Pressdruck zu beaufschlagen. Es wird insbesondere gewährleistet, dass jede Baugruppe individuell mit einem vorgegebenen Pressdruck beaufschlagt werden kann. Es wird u.a. vermieden, dass einzelne Baugruppen mit einem zu hohen oder zu niedrigen Pressdruck beaufschlagt werden, wie es beispielsweise bei herkömmlichen Lösungen der Fall ist, bei denen mehrere Baugruppen nur mit einem einzigen gemeinsamen Pressstempel beaufschlagt werden. Ein Vorteil besteht darin, dass Höhentoleranzen der Baugruppen bzw. Komponenten ausgeglichen bzw. berücksichtigt werden können. Das Einstellen der nötigen Presskraft kann beispielsweise mit Hilfe eines zugeordneten Kraft- oder Druckaufnehmers oder auch eines Wegaufnehmers erfolgen, wobei die ausgeübte Presskraft direkt durch Einstellen eines Arbeitsdrucks oder indirekt durch Einstellen eines Versatzweges der zweiten Pressstempel erfolgen kann. Eine hydraulisch ansteuerbare Antriebsvorrichtung kann beispielsweise durch eine Anordnung von doppelwirkenden Kolben gebildet werden, welche mittels entsprechender Steuerventile von einem gemeinsamen druckbeaufschlagten Fluidreservoir gespeist werden können. Eine elektromotorische Ansteuerung kann beispielsweise mit Hilfe einer einen Spindelantrieb aufweisenden Antriebsvorrichtung erfolgen. Des Weiteren können auch piezoelektrisch oder magnetostriktiv betriebene Antriebsvorrichtungen vorgesehen sein.

Gemäß einer weiteren bevorzugten Ausführungsform weist der mindestens eine zweite Pressstempel einen bevorzugt axial entlang einer Wirkrichtung der Presskraft versetzbaren Stempelkörper und eine mit einer Komponente der Baugruppe kontaktierbare Kontaktfläche auf, wobei die Kontaktfläche relativ zum Stempelkörper um zumindest eine Raumachse kippbar gelagert ist. Bevorzugt ist jedoch die Kontaktfläche um zwei kartesische Raumachsen kippbar, wobei die dritte Raumachse dieses kartesischen Raumachsensystems entlang der Wirkrichtung der Presskraft verläuft. Die Kontaktfläche ist damit sozusagen kardanisch gegenüber dem Presskörper beweglich, so dass sich die Kontaktfläche gleichmäßig an die mit ihr in Berührung stehende Komponente anlegen kann. Damit wird im Unterschied zu einer starr ausgerichteten Kontaktfläche, welche unter Umständen gegenüber der von ihr kontaktierten Komponente verkippt sein kann, das Auftreten von Kraftspitzen innerhalb der Komponenten vermieden und die Presskraft gleichmäßig verteilt. Die Ausrichtung der Kontaktfläche erfolgt dabei selbsttätig.

Gemäß einer weiteren bevorzugten Ausführungsform ist die Kontaktfläche mittels einer elastischen Ausgleichsschicht kippbar an dem Stempelkörper gelagert. Hierdurch wird eine kardanische Lagerung der Kontaktfläche bewirkt.

Gemäß einer weiteren bevorzugten Ausführungsform umfasst der zumindest eine Pressstempel eine erste und eine zweite Heizvorrichtung, wobei die zweite Heizvorrichtung eine Kontaktfläche zur direkten Wärmeübertragung an eine Komponente der Baugruppe aufweist und zwischen der ersten Heizvorrichtung und der Kontaktfläche angeordnet ist. Die von der ersten Heizvorrichtung erzeugte Wärme wird somit indirekt an die Komponente übertragen. Durch die serielle Anordnung von zwei Heizvorrichtung kann die Temperaturregelung im Bereich der Kontaktfläche zwischen dem Pressstempel und der damit in Kontakt stehenden Komponente der Baugruppe verbessert werden. Beispielsweise kann mittels der ersten Heizvorrichtung ein rasches Aufheizen auf eine Grundtemperatur erfolgen, während die zweite Heizvorrichtung eine Feinregelung der Temperatur ermöglicht. Die indirekte Wärmeübertragung erfolgt in einer Weise, dass die von der ersten Heizvorrichtung erzeugte Wärme mittelbar durch die zweite Heizvorrichtung hindurch an die Kontaktfläche und an die mit dieser in thermischem Kontakt stehende Komponente der Baugruppe übertragen wird. Die Kontaktfläche der zweiten Heizvorrichtung kann der vorstehend beschriebenen kardanisch gelagerten Kontaktfläche entsprechen.

Gemäß einer weiteren bevorzugten Ausführungsform ist die elastische Ausgleichsschicht zwischen der ersten und der zweiten Heizvorrichtung angeordnet. Dies führt dazu, dass die erste Heizvorrichtung gegenüber der bevorzugt am Stempelkörper angeordneten zweiten Heizvorrichtung kippbar bzw. kardanisch gelagert ist.

Gemäß einer weiteren bevorzugten Ausführungsform umfasst die Sintervorrichtung mehrere zweite Pressstempel, wobei jeder zweite Presstempel jeweils eine erste und eine zweite Heizvorrichtung umfasst, und wobei die ersten Heizvorrichtungen gemeinsam und die zweiten Heizvorrichtungen individuell geregelt sind. Wie bereits vorstehend erwähnt wurde, kann die Regelung der ersten Heizvorrichtungen so eingestellt sein, dass hier ein rasches Aufheizen auf eine Grundtemperatur erfolgt. Die gewünschte bauteilspezifische Endtemperatur kann individuell für jeden zweiten Pressstempel mittels der zugeordneten zweiten Heizvorrichtung eingestellt werden. Hierdurch wird die Genauigkeit der Temperaturregelung verbessert und insbesondere das Auftreten von Überschwingern vermindert.

Die vorliegende Erfindung betrifft in einem weiteren Aspekt ein Verfahren zum Steuern einer Sintervorrichtung nach einer der vorstehend beschriebenen erfindungsgemäßen oder bevorzugten Ausführungsformen, wobei der mindestens eine erste Pressstempel und der mindestens eine zweite Pressstempel jeweilige Kontaktflächen aufweisen, welche mittels jeweiligen Heizvorrichtungen und/oder Kühlvorrichtungen temperierbar sind und zwischen denen die zu verbindenden Komponenten aufgenommen sind, wobei die Heizvorrichtung und/oder Kühlvorrichtung derart gesteuert werden, dass zwischen einer ersten Temperatur an einer Kontaktfläche eines oder des ersten Pressstempels und einer zweiten Temperatur an einer Kontaktfläche eines oder des zweiten Pressstempels, welche der genannten Kontaktfläche des ersten Pressstempels gegenüberliegt, ein Temperaturunterschied besteht und dieser Temperaturunterschied gemäß einem vorbestimmten Gradientenverlauf, bevorzugt in Abhängigkeit von dem Absolutwert der ersten oder der zweiten Temperatur, gesteuert wird. Dies bedeutet, dass die einander gegenüberliegenden Kontaktflächen des ersten und des zweiten Pressstempels nicht mit derselben Temperatur oder einem gleichbleibenden Temperaturunterschied betrieben werden, sondern der Temperaturgradient oder Temperaturunterschied zwischen diesen beiden Kontaktflächen über die Zeit variieren kann, wobei der bestehende Temperaturgradient zwischen den beiden Kontaktflächen bevorzugt in Abhängigkeit von der Temperatur des ersten oder des zweiten Pressstempels, d.h. der ersten oder zweiten Temperatur, gesteuert werden kann. Der Gradientenverlauf kann also sowohl eine Funktion der Zeit als auch eine Funktion einer Absoluttemperatur sein, wobei auch eine Kombination aus beiden Möglichkeiten denkbar ist.

Gemäß einer vorteilhaften Ausgestaltung des Verfahrens weisen die zu verbindenden Komponenten unterschiedliche Wärmeausdehnungskoeffizienten auf, wobei der vorbestimmte Gradientenverlauf derart gewählt wird, dass während einer Aufwärmphase und/oder während einer Abkühlphase der zu verbindenden Komponenten das Maß einer thermischen Größenänderung einer mit der genannten Kontaktfläche des ersten Pressstempels in thermischer Verbindung stehenden Komponente dem Maß einer thermischen Größenänderung einer anderen, mit der genannten Kontaktfläche des zweiten Pressstempels in thermischer Verbindung stehenden Komponente entspricht. Beispielsweise kann die Baugruppe ein Substrat, welches mit der Kontaktfläche des zweiten Pressstempels in thermischere Verbindung steht, und ein Bauteil umfassen, welches mit dem ersten Pressstempel in thermischer Verbindung steht und mit dem Substrat zu der genannten Baugruppe verbunden werden soll. Wenn das Substrat und das Bauteil unterschiedliche Wärmeausdehnungskoeffizienten besitzen, weichen die durch Temperaturänderungen bedingen Größenänderungen voneinander ab, d.h. das Substrat und das Bauteil expandieren oder schrumpfen bei gleicher Temperatur um unterschiedliche Beträge, so dass es zu mechanischen Spannungen innerhalb der Baugruppe kommen kann. Mit dem erfindungsgemäßen Verfahren können durch eine gezielte Steuerung der Temperaturdifferenz, insbesondere in Abhängigkeit von einer Absoluttemperatur, die Differenzen der Größenänderungen reduziert und aneinander angeglichen werden. Beide Komponenten expandieren oder schrumpfen somit um das gleiche Maß, so dass sich im Wesentlichen keine mechanischen Spannungen in der Baugruppe aufbauen können.

Gemäß einer weiteren bevorzugten Ausgestaltung des Verfahrens wird die erste Temperatur träge und die zweite Temperatur dynamisch geregelt oder die erste Temperatur wird dynamisch und die zweite Temperatur träge geregelt, um den vorbestimmten Gradientenverlauf bereitzustellen. Bei einer geeigneten Sintervorrichtung kann beispielsweise das Oberwerkzeug mit dem zumindest einen ersten Pressstempel aufgrund einer großen Masse thermisch träge sein. Die Temperatur des Oberwerkzeugs bzw. des ersten Pressstempels kann beispielsweise einem vorgegebenen Temperaturverlauf folgen. Die eigentliche Steuerung der Temperaturdifferenz, die durch den Gradientenverlauf bestimmt ist, kann mittels des Unterwerkzeugs bzw. des zumindest einen daran angeordneten zweiten Pressstempels erfolgen, wobei dieser eine kleinere Masse besitzen kann und damit auch eine größere Temperaturänderungsrate als das Oberwerkzeug bzw. der erste Pressstempel aufweisen kann. Die Temperatur des Unterwerkzeugs bzw. des zumindest einen zweiten Pressstempels wird dementsprechend dynamischer geregelt, so dass die tatsächliche Temperaturdifferenz dem vorbestimmten Gradientenverlauf folgt.

Die notwendigen Temperaturmessungen können durch in die Werkzeuge bzw. Pressstempel integrierte Sensoren oder auch durch Messung der Oberflächentemperatur der Komponenten, z.B. mittels Pyrometer, erfolgen. Oftmals weisen zu verbindende elektronische Bauelemente oder Bauteile integrierte Temperatursensoren auf, z.B. vom Typ Pt1000, deren Messwerte in die Steuerung der Temperatur- bzw. Gradientenverläufe einbezogen werden können.

### ZEICHNUNGEN

Weitere Vorteile ergeben sich aus der Zeichnung und der zugehörigen Zeichnungsbeschreibung. In den Zeichnungen sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine schematische Teilansicht in perspektivischer Schnittdarstellung einer Sintervorrichtung gemäß einem ersten Ausführungsbeispiel;
- Fig. 2 und 3: perspektivische Teilansichten der Sintervorrichtung von Fig. 1;
- Fig. 4: eine schematische perspektivische Ansicht einer Halterungsplatte der Sintervorrichtung von Fig. 1 bis 3;
- Fig. 5 und 6: schematische Seitenansichten der Halterungsplatte von Fig. 4;
- Fig. 7: eine schematische Schnittansicht einer Sintervorrichtung gemäß einem zweiten Ausführungsbeispiel;
- Fig. 8: eine schematische Schnittansicht einer Sintervorrichtung gemäß einem dritten Ausführungsbeispiel;
- Fig. 9: eine schematische Schnittansicht einer elektronischen Baugruppe; und
- Fig. 10: eine schematische Temperaturverlaufskurve.

Im Folgenden werden für gleiche oder gleichartige Elemente oder Komponenten die gleichen Bezugszeichen verwendet.

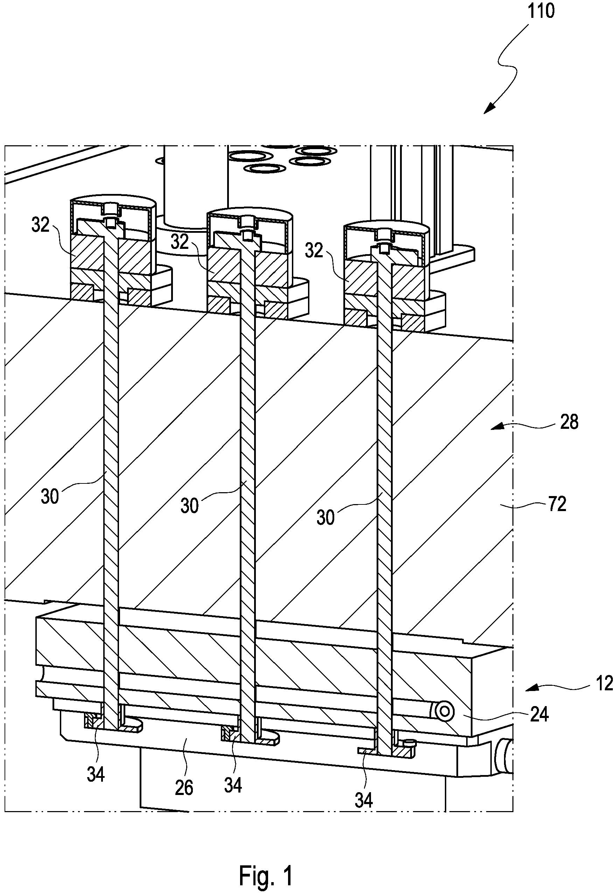

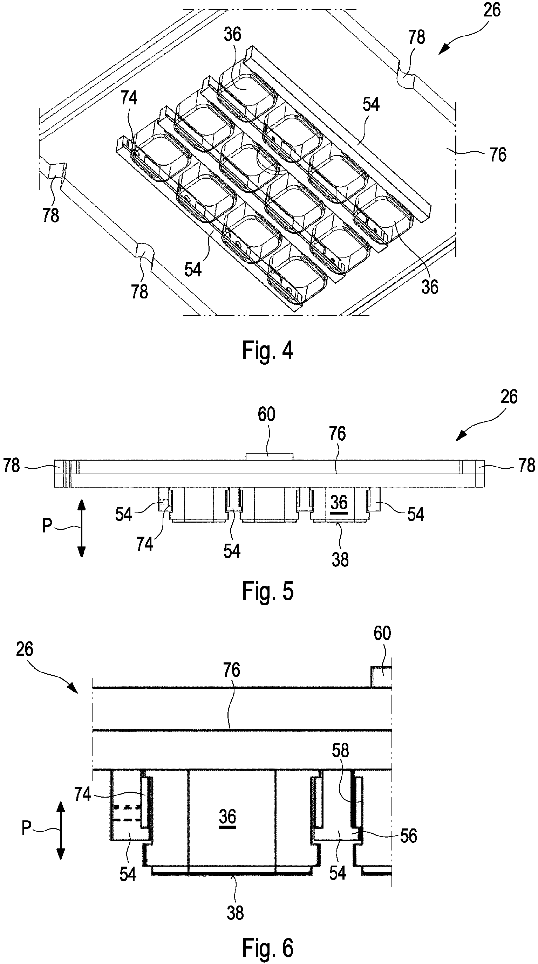

Fig. 1 zeigt eine Sintervorrichtung 110 gemäß einem ersten Ausführungsbeispiel, welche ein Oberwerkzeug 12 und ein nicht dargestelltes Unterwerkzeug umfasst. Die Sintervorrichtung 110 umfasst ein massives Pressengestell 72, welches eine evakuierbare Prozesskammer umgrenzen kann und an dessen Unterseite eine Grundplatte 24 als Bestandteil des Oberwerkzeugs 12 angeordnet ist. Das Oberwerkzeug 12 umfasst ferner eine Halterungsplatte 26, in welcher gemäß Fig. 4 bis 6 eine Vielzahl von ersten Pressstempeln 36 angeordnet sind. In der Grundplatte 24 und/oder in der Halterungsplatte 26 können Heiz- und/oder Kühlvorrichtungen (nicht dargestellt) vorgesehen sein.

Am Oberwerkzeug 12 ist eine Spannvorrichtung 28 vorgesehen, mit welcher die Halterungsplatte 26 lösbar an der Grundplatte 24 befestigt werden kann. Die Spannvorrichtung 28 umfasst mehrere Wellen 30, die durch das Pressengestell 72 und die Grundplatte 24 hindurchgeführt sind und mittels an der Oberseite des Pressengestells 72 angeordnete Wellenantriebe 32 rotierbar angetrieben werden können. Die Wellenantriebe 32 liegen somit außerhalb der Prozesskammer.

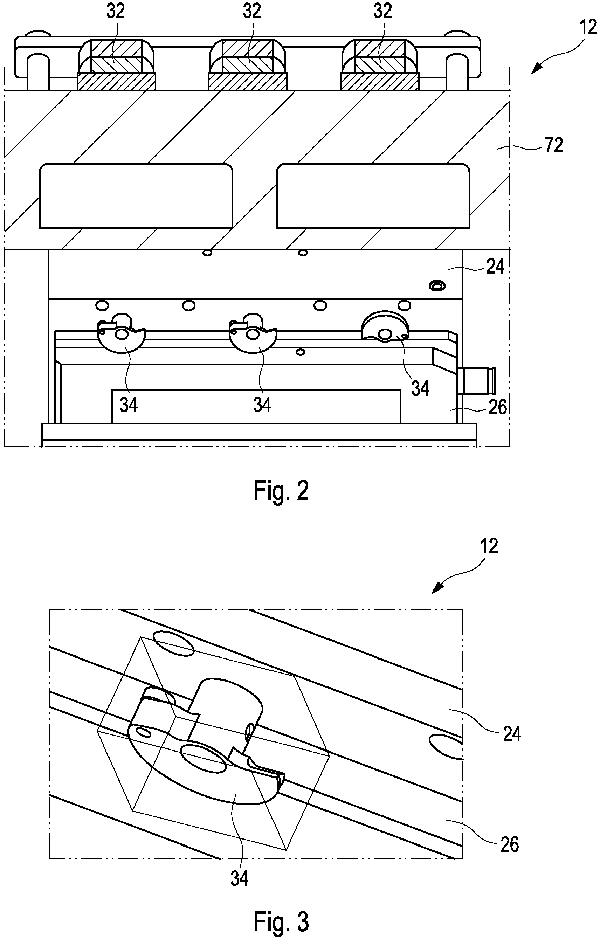

Wie auch Fig. 2 und 3 zeigen, ist am freien, dem Wellenantrieb 32 gegenüberliegenden Ende einer jeweiligen Welle 30 ein als Exzenter ausgebildeter Verriegelungsabschnitt 34 angeordnet, welcher mit der Halterungsplatte 26 zusammenwirkt. Wie in Fig. 2 zu erkennen ist, befinden sich der mittlere und der linke Verriegelungsabschnitt 34 in einer Verriegelungsstellung, während sich der rechte Verriegelungsabschnitt 34 in einer Freigabestellung befindet. Wenn sich alle Verriegelungsabschnitte 34 in einer Freigabestellung befinden, kann die Halterungsplatte 26 von der Grundplatte 24 gelöst werden. Die Wellenantriebe 32 können beispielsweise als elektrisch betriebene Getriebemotoren oder als pneumatische Antriebe ausgestaltet sein.

Die Befestigung der Halterungsplatte 26 mittels der von außen angetriebenen Verriegelungsabschnitte 34 ermöglicht bei automatisierten Sinteranlagen, bei denen die Werkstückzuführung über Förderanlagen erfolgt, einen raschen Austausch gegen eine anders konfigurierte Werkzeuganordnung ohne Eingriff einer Bedienperson in das Innere der Sinterkammer, wobei die Abfuhr der bisherigen Werkzeuganordnung und die Zufuhr der neuen Werkzeuganordnung über die Förderlage erfolgen kann. Hierdurch können die Rückseiten verkürzt werden.

Mit Bezug nun auf Fig. 4 bis 6 wird die Ausgestaltung der Halterungsplatte 26 näher beschrieben. Die Halterungsplatte 26 umfasst einen Grundkörper, an dessen Unterseite mehrere längliche, parallel verlaufende Halteleisten 54 vorgesehen sind. Die Halteleisten 54 stellen somit Teilabschnitte der Halterungsplatte 26 dar. Die Halteleisten 54 weisen an ihren freien Enden einen oder zwei seitlich hervorstehende Absätze 56 auf, welche in jeweilige Nuten 58 eingreifen, die an den Seitenwandungen von zwischen jeweils zwei Halteleisten 54 aufgenommenen ersten Pressstempeln 36 eingreifen. Die ersten Pressstempel 36 weisen an ihrer Unterseite jeweilige Kontaktflächen 38 auf, die während des Sintervorgangs direkt oder indirekt mit zu verbindenden Komponenten einer elektronischen Baugruppe kontaktierbar sind.

Im vorliegenden Ausführungsbeispiel umfasst die Halterungsplatte 26 insgesamt vier Halteleisten 54, wobei zwischen jeweils zwei Halteleisten 54 vier erste Pressstempel 36 eingeschoben sind. Insgesamt umfasst die Halterungsplatte 26 im dargestellten Ausführungsbeispiel drei Reihen zu je vier ersten Pressstempeln 36. Es versteht sich, dass sowohl die Anzahl an Reihen als auch die Anzahl an ersten Pressstempeln 36 je Reihe variiert werden kann. Obwohl im Ausführungsbeispiel alle ersten Pressstempel 36 gleich groß dargestellt sind, kann auch die Größe der Pressstempel 36 variieren.

Die Halteleisten 54 und die ersten Pressstempel 36 können aus Materialien mit unterschiedlichen Wärmeausdehnungskoeffizienten hergestellt sein. Beispielsweise können die Halteleisten 54 einen größeren Wärmeausdehnungskoeffizienten als die ersten Pressstempel 36 und auch als der Grundkörper 76 der Halterungsplatte 26 aufweisen. Alternativ oder zusätzlich können zwischen den Halteleisten 54 und dem ersten Pressstempel 36 im Bereich der Nuten 58 jeweilige Klemmstreifen 74 angeordnet sein, die im Vergleich zu den ersten Pressstempeln 36 und/oder den Halteleisten 54 einen höheren Wärmeausdehnungskoeffizienten besitzen.

Beispielsweise können die Halteleisten 54 aus Molybdän mit einem Wärmeausdehnungskoeffizienten von 5,2 ×10⁻⁶/K hergestellt sein und mit dem Grundkörper 76 verschraubt sein, während die Klemmstreifen 74 aus Aluminium mit einem Wärmeausdehnungskoeffizienten von 24 × 10⁻⁶/K hergestellt sein können. Die ersten Pressstempel 36 können zum Beispiel aus Stahl mit einem Wärmeausdehnungskoeffizienten von 11 × 10⁻⁶/K gefertigt sein. Die Dimensionen der genannten Komponenten können so gewählt sein, dass die Pressstempel bei einer ersten Temperatur, z.B. bei 20°C zwischen den Halteleisten 54 in der Wegrichtung der Presskraft P versetzt werden können, wobei ein Zusammenwirken der Absätze 56 und der zugeordneten Nuten 58 ein Herausfallen der ersten Pressstempel 36 aus der Halterungsplatte 26 verhindern. Da die Höhe der Absätze 56 kleiner ist als die Höhe der zugeordneten Nuten 58, wird das hierfür notwendige Längsspiel, d.h. einem in einer Wirkrichtung der Presskraft P verlaufenden Höhenspiel gewährleistet.

Wird die Halterungsplatte 26 mit den ersten Pressstempeln 36 auf oder über eine zweite Temperatur, z.B. 100°C oder mehr erwärmt, bewirkt die vergleichsweise größere thermische Ausdehnung der Halteleisten 54 bzw. der Klemmstreifen 74 eine Verringerung des Abstandes zwischen den einander zugewandten Kontaktflächen benachbarter Halteleisten 54 bzw. Klemmstreifen 74, so dass die ersten Pressstempel 36 nunmehr zwischen den Halteleisten 54 verklemmt und somit in ihrer Lage fixiert sind.

Gemäß einer nicht dargestellten Abwandlung kann eine Sicherung der ersten Pressstempel 36 gegen Herausfallen auch mit Hilfe von Schrauben erfolgen, die durch die Halterungsplatte hindurch von oben in die ersten Pressstempel 36 eingeschraubt sind und mit ihrem Schraubenkopf innerhalb einer jeweiligen Aufnahme in der Halterungsplatte 26 gehalten sind. Ein nur unvollständiges Hineindrehen in die ersten Pressstempel 36 gewährleistet ein Höhenspiel. Die Schraubenköpfe können beispielsweise auch in schlitzförmigen Führungsausnehmungen in der Halterungsplatte 26 verschieblich gehalten und ggf. nach Art einer Kulissenführung ausgerichtet werden.

Gemäß einer weiteren nicht dargestellten Abwandlung kann die Sicherung der ersten Pressstempel an der Halterungsplatte 26 gegen Herausfallen auch mit Hilfe von wärmebeständigen Dauermagneten erfolgen.

Die in Fig. 4 bis 6 dargestellte Werkzeuganordnung kann wie dargestellt als Oberwerkzeug 12 und alternativ oder zusätzlich auch in entsprechender Weise als Unterwerkzeug ausgestaltet sein. Der Grundkörper 76 der Halterungsplatte 26 kann an seinem Umfang mehrere Zentriernuten 78 und an seiner Oberseite einen Zentrierdorn 60 aufweisen, so dass durch ein Zusammenwirken mit entsprechenden Passerstiften oder dergleichen, insbesondere auch mit den Wellen 30, eine lagerichtige Kopplung mit der Grundplatte 24 erfolgen kann.

Die ersten Pressstempel 36 können bei kalter oder relativ kühler Werkzeuganordnung, d.h. kleiner oder gleich der ersten Temperatur, auf die zu verbindenden Komponenten einer jeweiligen Baugruppe oder mittels einer Richtlehre ausgerichtet werden. Anschließend kann die Werkzeuganordnung auf oder über die zweite Temperatur erwärmt werden. Nun kann die Werkzeuganordnung mit den zu verbindenden Komponenten einer Baugruppe in Kontakt gebracht werden, um den eigentlichen Sintervorgang durchzuführen.

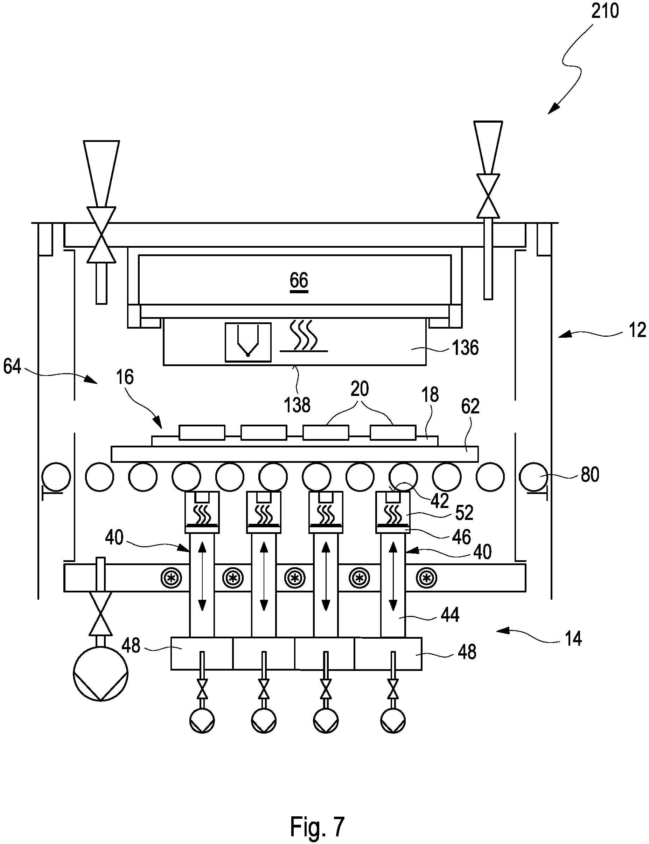

Mit Bezug nun auf Fig. 7 wird eine Sintervorrichtung 210 gemäß einem zweiten Ausführungsbeispiel betrieben. Die Sintervorrichtung 210 weist eine evakuierbare Prozesskammer 64 auf, in welche über nicht näher beschriebene Ventile Prozessgase ein- und ausgeleitet werden können. Innerhalb der Prozesskammer 64 sind ein Oberwerkzeug 12 und ein Unterwerkzeug 14 angeordnet. Mittels einer Transportvorrichtung 80 kann ein Werkstückträger 62 mit den zu verbindenden Komponenten in die Prozesskammer 64 eingeführt und nach erfolgtem Sintervorgang aus dieser heraustransportiert werden. Im Ausführungsbeispiel ist auf dem Werkstückträger 62 lediglich eine einzige Baugruppe 16 dargestellt, welche ein Substrat 18, beispielsweise einen Kühlkörper und mehrere elektronische Bauteile 20 umfasst, die durch den Sintervorgang mit dem Substrat 18 verbunden werden sollen. Es versteht sich, dass auf einem Werkstückträger 62 auch mehrere Baugruppen 16 vorgesehen sein können.

Die Baugruppe 16 befindet sich zwischen dem Oberwerkzeug 12 und dem Unterwerkzeug 14.

Das Oberwerkzeug 12 umfasst einen Heizblock 66, an dessen Unterseite ein erster Pressstempel 136 mit einer der Baugruppe 16 zugewandten Kontaktfläche 138 bevorzugt lösbar befestigt ist. Es versteht sich, dass anstelle eines einzigen Pressstempels 136 auch eine Werkzeuganordnung mit mehreren in einer Halterungsplatte 26 angeordneten ersten Pressstempeln 36 gemäß dem ersten Ausführungsbeispiel (Fig. 1 bis 6) vorgesehen sein kann.

Das Unterwerkzeug 14 umfasst mehrere unabhängig voneinander versetzbare zweite Pressstempel 40, wobei jedem der zweiten Pressstempel 40 eine jeweilige Antriebsvorrichtung 48 zum axialen Versetzen dieses Pressstempels 40 entlang einer Wirkrichtung der Presskraft P zugeordnet ist. Die Antriebsvorrichtungen 48 sind im Ausführungsbeispiel als hydraulisch betätigte Antriebsvorrichtungen 48 dargestellt und können beispielsweise einen doppelt wirkenden Kolben umfassen, der über jeweilige Steuerventile mit einem unter Druck stehenden Hydraulikfluid beaufschlagt werden kann.

Jeder zweite Pressstempel 40 umfasst einen Stempelkörper 44 und eine oberhalb angeordnete Heizvorrichtung 52, wobei zwischen der Heizvorrichtung 52 und dem Stempelkörper 44 eine elastische Ausgleichsschicht 46 vorgesehen ist. An der Oberseite der Heizvorrichtung 52 ist eine Kontaktfläche 42 ausgebildet, welche während des Sintervorgangs mit der Baugruppe 16 kontaktiert wird, um Presskraft und Prozesswärme auf die Baugruppe 16 zu übertragen. Die elastische Ausgleichsschicht 46 bewirkt eine sozusagen kardanische Lagerung der Heizvorrichtung 52, so dass sich die Kontaktfläche 42 parallel zu einer gegenüberliegenden Kontaktfläche der Baugruppe 16 ausrichten kann, so dass eine gleichmäßige Übertragung von Presskraft und Prozesswärme unter Vermeidung von Temperatur- bzw. Kraftspitzen erfolgen kann. Die Stempelkörper 44 können zusätzlich mit einer weiteren Heizvorrichtung oder einer Kühlvorrichtung in thermischem Kontakt stehen, um ein rascheres Aufheizen und Abkühlen der zweiten Pressstempel 40 zu gewährleisten. Während des Sintervorgangs werden die durch das Versetzen der zweiten Pressstempel 40 die Baugruppen 16 aus dem Werkstückträger 62 ausgehoben. Nach dem Lösen des Pressdrucks fallen die Baugruppen 16 wieder zurück in den Werkstückträger 62.

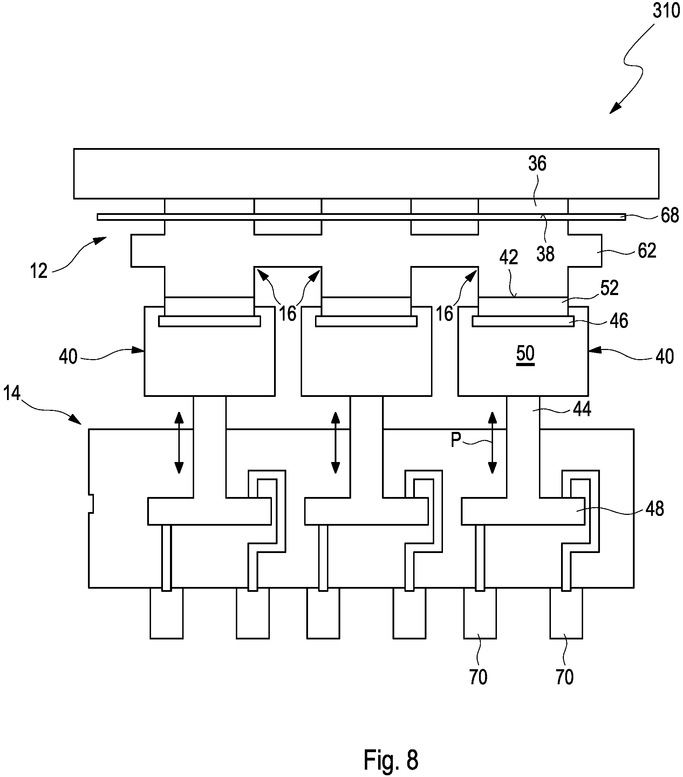

Mit Bezug auf Fig. 8 wird nun eine Sintervorrichtung 310 gemäß einem dritten Ausführungsbeispiel beschrieben, welche der Sintervorrichtung 210 von Fig. 7 ähnelt. Daher werden im Folgenden lediglich die wesentlichen Unterschiedsmerkmale erläutert. Anstelle eines durchgehenden ersten Pressstempels 136 weist die Sintervorrichtung 310 mehrere erste Pressstempel 36 auf. Die ersten Pressstempel 36 können entsprechend der Sintervorrichtung 110 (Fig. 1 bis 6) bezüglich ihrer jeweiligen Höhe und/oder Position konfigurierbar sein oder auch fest an einem gemeinsamen Stempelträger angeordnet sein. Zwischen den ersten Pressstempeln 36 und den Baugruppen 16 kann eine bevorzugt elastische Ausgleichsfolie 68 oder Trennfolie angeordnet werden, um eine Verschmutzung der ersten Pressstempel 36 bzw. ein Verkleben mit den Baugruppen 16 zu verhindern und insbesondere auch durch ihre Elastizität eine gleichmäßige Verteilung des Pressdrucks zu bewirken. Das Unterwerkzeug 14 umfasst wiederum mehrere zweite Pressstempel 40, wobei jeder zweite Presstempel einer Baugruppe 16 und einem jeweiligen ersten Pressstempel 36 zugeordnet ist. Der Stempelkörper 44 eines zweiten Presstempels 44 weist eine erste Heizvorrichtung 50 auf, an welcher über eine flexible Ausgleichsschicht 46 eine zweite Heizvorrichtung 52 gekoppelt ist. Die flexible Ausgleichsschicht 46 ermöglicht eine kardanische Ausrichtung der Kontaktfläche 42 des zweiten Pressstempels 40. Weiterhin sind Hydraulikventile 70 dargestellt, welche eine Beaufschlagung der Antriebsvorrichtungen 48 mit Hydraulikfluid steuern können.

Nachfolgend wird ein Verfahren zum Steuern einer Sintervorrichtung, insbesondere einer Sintervorrichtung 110, 210, 310 gemäß einem der hier beschriebenen Ausführungsbeispiele, zum Verbinden von Komponenten elektronischer Baugruppen beschrieben.

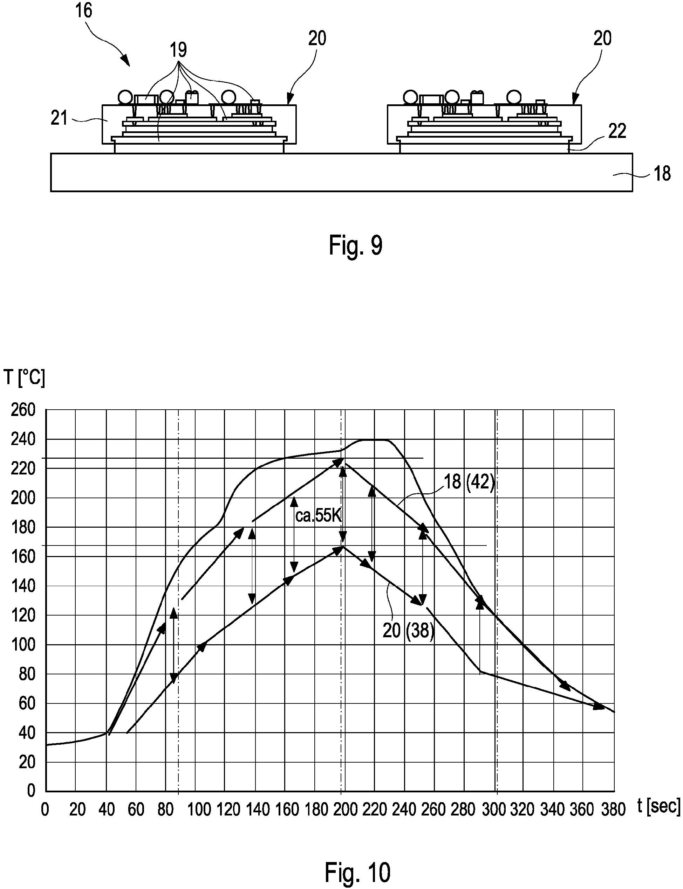

Bei der Herstellung von Vorrichtungen der Leistungselektronik, beispielsweise Umrichter oder dergleichen, werden oftmals elektronische Bauelemente oder Bauteile, insbesondere auch vorgefertigte Bauelementstapel, mit einem gemeinsamen Substrat, beispielsweise einem Kühlkörper, durch Sintern verbunden. Eine derartige Baugruppe 16 ist beispielhaft in Fig. 9 dargestellt. Mehrere miteinander verbundene Bauelemente 19 oder Bauelementstapel können mit einer Vergussmasse 21 zu einem sogenannten "Mold" 20 vergossen sein. Ein oder mehrere solcher Molds 20 werden dann mit Hilfe eines Sinterverfahrens mit einem gemeinsamen Kühlkörper 18 verbunden, wobei zwischen den Molds 20 und dem Kühlkörper 18 das zu sinternde Fügematerial 22 vorgesehen wird.

Im beschriebenen Ausführungsbeispiel stehen die Molds 20 mit dem Oberwerkzeug 12 und das Substrat bzw. der Kühlkörper 18 mit dem Unterwerkzeug 14 in mechanischem und thermischem Kontakt. Bei einem herkömmlichen Sinterverfahren werden die zu verbindenden Komponenten 18, 20 einer Baugruppe 16 auf die Sintertemperatur erwärmt und anschließend wieder auf Umgebungstemperatur abgekühlt. Dabei beträgt der Temperaturunterschied zwischen den Komponenten, d.h. beispielsweise zwischen den elektrischen Bauteilen oder Molds 20 einerseits und dem Substrat oder Kühlkörper 18 andererseits in der Regel nicht mehr als 10 K. Wenn der Mold 20 und der Kühlkörper 18 unterschiedliche Wärmeausdehnungskoeffizienten besitzen, weichen die durch Temperaturänderungen bedingten Größenänderungen voneinander ab, d.h. die Molds 20 und das Substrat 18 expandieren oder schrumpfen um unterschiedliche Beträge, so dass es zu mechanischen Spannungen innerhalb der Baugruppe 16 kommen kann.

Um dies zu vermeiden, werden die Heizvorrichtungen bzw. die Kühlvorrichtungen einer Sintervorrichtung 110, 210, 310 derart gesteuert, dass zwischen einer ersten Temperatur an einer Kontaktfläche 38, 138 eines ersten Pressstempels 36, 136 und einer zweiten Temperatur an einer Kontaktfläche 42 eines zweiten Pressstempels 40, welche der genannten Kontaktfläche 38, 138 des ersten Pressstempels 36, 136 gegenüberliegt, ein Temperaturunterschied besteht und dieser Temperaturunterschied gemäß einem vorbestimmten Gradientenverlauf gesteuert wird. Ein derartiger Gradientenverlauf ist in Fig. 10 in Form eines Temperatur/Zeit-Diagramms dargestellt. Dort repräsentiert die untere Kurve den Temperaturverlauf an den Molds 20, welcher annähernd dem Temperaturverlauf an der Kontaktfläche 38 des ersten Pressstempels 36 entspricht, und die obere Kurve dem Temperaturverlauf an dem Kühlkörper 18, welcher annähernd dem Temperaturverlauf an der Kontaktfläche 42 des zweiten Pressstempels 40 entspricht. Bei der Bauteilkombination, die dem Gradientenverlauf von Fig. 10 zugrundeliegt, weisen die Molds 20 einen höheren Wärmeausdehnungskoeffizienten als der Kühlkörper 18 auf. Dementsprechend wird der vorbestimmte Gradientenverlauf derart gewählt, dass während der Aufwärmphase bzw. während der Abkühlphase der zu verbindenden Bauelemente 18, 20 das Maß einer thermischen Größenänderung der mit einer jeweiligen Kontaktfläche 38 eines ersten Pressstempels 36 in thermischer Verbindung stehenden Molds 20 dem Maß einer thermischen Größenänderung des mit der Kontaktfläche 42 des zweiten Pressstempels 40 in Verbindung stehenden Kühlkörpers 18 entspricht. Beide Komponenten 18, 20 schrumpfen somit um das gleiche Maß, so dass sich im Wesentlichen keine mechanischen Spannungen in der Baugruppe 16 aufbauen können.

Die Steuerung des Gradientenverlaufs, d.h. insbesondere der Temperaturdifferenz, erfolgt beispielsweise in Abhängigkeit von dem Absolutwert der Temperatur an einer bestimmten Komponente 18, 20 oder an einer der Kontaktflächen 36, 38 als Referenzposition. So kann wie im beschriebenen Beispiel die Temperaturdifferenz mit steigender Absoluttemperatur zunehmen und mit fallender Temperaturdifferenz wieder abnehmen.

Bei einer geeigneten Sintervorrichtung kann beispielsweise das Oberwerkzeug 12 aufgrund einer großen Masse thermisch träge sein. Die Temperatur des Oberwerkzeugs 12 kann beispielsweise einem vorgegebenen Temperaturverlauf folgen. Die eigentliche Steuerung der Temperaturdifferenz bzw. des Temperaturgradienten kann mittels des Unterwerkzeugs 14 erfolgen, welches eine kleinere Masse aufweist und damit auch eine größere Temperaturänderungsrate als das Oberwerkzeug 12 aufweist. Die Temperatur des Unterwerkzeugs 14 wird dementsprechend dynamischer geregelt, so dass die tatsächliche Temperaturdifferenz dem vorbestimmten Temperaturgradientenverlauf folgt. Der Temperaturgradientenverlauf ist so gewählt, dass der im hier beschriebenen Beispiel höhere Wärmeausdehnungskoeffizient der Molds 20 im Vergleich zum Wärmeausdehnungskoeffizienten des Kühlkörpers 18 durch eine niedrigere Werkstücktemperatur der Molds 20 im Vergleich zur Werkstücktemperatur des Kühlkörpers 18 kompensiert wird. Die notwendigen Temperaturmessungen können durch in die Werkzeuge, insbesondere in die Pressstempel 36, 136, 40 integrierte Temperatursensoren oder auch durch Messungen der Oberflächentemperatur der Komponenten der Baugruppe 16, z.B. mittels Pyrometer, erfolgen.

Oftmals weisen die zu verbindenden Komponenten integrierte Temperatursensoren auf, z.B. vom Typ Pt1000, deren Messwerte in die Steuerung der Temperaturverläufe einbezogen werden können.

### Bezugszeichenliste

- 110,210,310: Sintervorrichtung
- 12: Oberwerkzeug
- 14: Unterwerkzeug
- 16: Baugruppe
- 18: Substrat, Kühlkörper
- 19: Bauelement
- 20: elektrisches Bauteil, Mold
- 21: Vergussmasse
- 22: Fügematerial
- 24: Grundplatte
- 26: Halterungsplatte
- 28: Spannvorrichtung
- 30: Welle
- 32: Wellenantrieb
- 34: Verriegelungsabschnitt
- 36, 136: erster Pressstempel
- 38, 138: Kontaktfläche des ersten Pressstempels
- 40: zweiter Pressstempel
- 42: Kontaktfläche des zweiten Pressstempels
- 44: Stempelkörper
- 46: Ausgleichsschicht
- 48: Antriebsvorrichtung, Kolben
- 50: erste Heizvorrichtung
- 52: zweite Heizvorrichtung, Heizvorrichtung
- 54: Halteleiste
- 56: Absatz
- 58: Nut
- 60: Zentrierdorn
- 62: Werkstückträger
- 64: Prozesskammer
- 66: Heizblock
- 68: Ausgleichsfolie
- 70: Hydraulikventil
- 72: Pressengestell
- 74: Klemmstreifen
- 76: Grundkörper
- 78: Zentriernut
- 80: Transportvorrichtung
- P: Presskraft

## Patentansprüche

1. Sintervorrichtung (110, 210, 310) zum gleichzeitigen Verbinden von Komponenten (18, 20) mehrerer nebeneinander angeordneter elektronischer Baugruppen (16) mittels Drucksintern, umfassend mindestens einen ersten Pressstempel (36, 136) und mindestens einen zweiten Pressstempel (40), zwischen denen die Baugruppen (16) aufgenommen sind und welche zum Ausüben einer Presskraft (P) relativ zueinander bezüglich ihres Abstandes versetzbar sind, wobei die ersten und/oder zweiten Pressstempel (36, 136, 40) zur Anpassung an eine jeweilige Höhe und/oder Position der Baugruppe (16) konfigurierbar sind.

2. Sintervorrichtung (110, 210, 310) nach Anspruch 1, **dadurch gekennzeichnet, dass** die Sintervorrichtung (110, 210, 310) mehrere erste Pressstempel (36) umfasst, welche, bevorzugt austauschbar, an einer gemeinsamen Halterungsplatte (26) angeordnet sind.

3. Sintervorrichtung (110, 210, 310) nach Anspruch 1 oder 2, **dadurch gekennzeichnet, dass** die Halterungsplatte (26) an einer bevorzugt temperierbaren Grundplatte (24) der Sintervorrichtung (110, 210, 310) lösbar mittels einer Spannvorrichtung (28) befestigt ist.

4. Sintervorrichtung (110, 210, 310) nach Anspruch 3, **dadurch gekennzeichnet, dass** die Spannvorrichtung (28) mehrere manuell oder motorisch rotierbare Wellen (30) aufweist, welche jeweils an einem freien Ende einen bevorzugt als Exzenter ausgebildeten Verriegelungsabschnitt (34) aufweisen, wobei die Wellen (30) zwischen einer Verriegelungsstellung, in welcher die Halterungsplatte (26) mittels der Verriegelungsabschnitte (34) an der Grundplatte (24) festgelegt ist, und einer Freigabestellung, in welcher die Verriegelungsabschnitte die Halterungsplatte (26) freigeben, rotierbar ist.

5. Sintervorrichtung (110, 210, 310) nach einem der Ansprüche 2 bis 4, **dadurch gekennzeichnet, dass** die ersten Presstempel (26) bei einer ersten Temperatur entlang einer Wirkrichtung der Presskraft (P) versetzbar an oder in der Halterungsplatte (26) aufgenommen sind und bei einer zweiten Temperatur, die höher ist als die erste Temperatur, an oder in der Halterungsplatte (26) verklemmt sind.

6. Sintervorrichtung (110, 210, 310) nach Anspruch 5, **dadurch gekennzeichnet, dass** die Halterungsplatte (26) zumindest in einem mit jeweiligen, mit einem der ersten Pressstempel (36) zusammenwirkenden Teilabschnitt einen höheren oder einen niedrigeren Wärmeausdehnungskoeffizienten aufweist als der jeweilige erste Pressstempel (36).

7. Sintervorrichtung (110, 210, 310) nach einem der vorhergehenden Ansprüche, **dadurch gekennzeichnet, dass** die Sintervorrichtung (110, 210, 310) mehrere unabhängig voneinander versetzbare zweite Pressstempel (40) umfasst, wobei jedem der zweiten Pressstempel (40) eine jeweilige Antriebsvorrichtung (48) zum axialen Versetzen dieses Pressstempels (40) entlang einer Wirkrichtung der Presskraft (P) zugeordnet ist, und wobei jede Antriebsvorrichtung (48) hinsichtlich eines Versatzwegs und/oder einer ausgeübten Presskraft (P) individuell, bevorzugt hydraulisch, elektromotorisch, piezoelektrisch oder magnetostriktiv, ansteuerbar ist.

8. Sintervorrichtung (110, 210, 310) nach einem der vorhergehenden Ansprüche, **dadurch gekennzeichnet, dass** der mindestens eine zweite Pressstempel (40) einen bevorzugt axial entlang einer Wirkrichtung der Presskraft (P) versetzbaren Stempelkörper (44) und eine mit einer Komponente der Baugruppe (16) kontaktierbare Kontaktfläche (42) aufweist, wobei die Kontaktfläche (42) relativ zum Stempelkörper (44) um zumindest eine Raumachse kippbar gelagert ist.

9. Sintervorrichtung (110, 210, 310) nach Anspruch 8, **dadurch gekennzeichnet, dass** die Kontaktfläche (42) mittels einer elastischen Ausgleichsschicht (46) kippbar an dem Stempelkörper gelagert ist.

10. Sintervorrichtung (110, 210, 310) nach einem der vorhergehenden Ansprüche, **dadurch gekennzeichnet, dass** der mindestens eine zweite Presstempel (40) eine erste und eine zweite Heizvorrichtung (50, 52) umfasst, wobei die zweite Heizvorrichtung (52) eine Kontaktfläche (42) zur direkten Wärmeübertragung an eine Komponente (18, 20) der Baugruppe (16) aufweist und zwischen der ersten Heizvorrichtung (50) und der Kontaktfläche (42) angeordnet ist.

11. Sintervorrichtung (110, 210, 310) nach den Ansprüchen 9 und 10, **dadurch gekennzeichnet, dass** die elastische Ausgleichsschicht (46) zwischen der ersten und der zweiten Heizvorrichtung (50, 52) angeordnet ist.

12. Sintervorrichtung (110, 210, 310) nach Anspruch 10 oder 11, **dadurch gekennzeichnet, dass** die Sintervorrichtung (110, 210, 310) mehrere zweite Presstempel (40) umfasst, wobei jeder zweite Presstempel jeweils eine erste und eine zweite Heizvorrichtung (50, 52) umfasst, und wobei die ersten Heizvorrichtungen (50) gemeinsam und die zweiten Heizvorrichtungen (52) individuell geregelt sind.

13. Verfahren zum Steuern einer Sintervorrichtung (110, 210, 310) nach einem der vorhergehenden Ansprüche, wobei der mindestens eine erste Pressstempel (36, 136) und der mindestens eine zweite Pressstempel (40) jeweilige Kontaktflächen (38. 138, 42) aufweisen, welche mittels jeweiligen Heizvorrichtungen (50, 52) und/oder Kühlvorrichtungen temperierbar sind und zwischen denen die zu verbindenden Komponenten (18, 20) aufgenommen sind, wobei die Heizvorrichtungen (50, 52) und/oder Kühlvorrichtungen derart gesteuert werden, dass zwischen einer ersten Temperatur an einer Kontaktfläche (38, 138) eines oder des ersten Presstempels(36, 136) und einer zweiten Temperatur an einer Kontaktfläche (42) eines oder des zweiten Presstempels (40), welche der genannten Kontaktfläche (38, 138) des ersten Presstempels (36, 136) gegenüberliegt, ein Temperaturunterschied besteht und dieser Temperaturunterschied gemäß einem vorbestimmten Gradientenverlauf, bevorzugt in Abhängigkeit von dem Absolutwert der ersten oder der zweiten Temperatur, gesteuert wird.

14. Verfahren nach Anspruch 13, wobei die zu verbindenden Komponenten (18, 20) unterschiedliche Wärmeausdehnungskoeffizienten aufweisen, und wobei der vorbestimmte Verlauf derart gewählt wird, dass während einer Aufwärmphase und/oder während einer Abkühlphase der zu verbindenden Komponenten (18, 20) das Maß einer thermischen Größenänderung einer mit der genannten Kontaktfläche (38, 138) des ersten Presstempels (36, 136) in thermischer Verbindung stehenden Komponente (18, 20) dem Maß einer thermischen Größenänderung einer anderen, mit der genannten Kontaktfläche (42) des zweiten Presstempels (40) in thermischer Verbindung stehenden Komponente (18, 20) entspricht.

15. Verfahren nach Anspruch 13 oder 14, wobei die erste Temperatur träge und die zweite Temperatur dynamisch geregelt wird, oder die erste Temperatur dynamisch und die zweite Temperatur träge geregelt wird, um den vorbestimmten Gradientenverlauf bereitzustellen.
